(19) Europäisches Patentamt
European Patent Office
Office européen des brevets

(11) **EP 4 160 233 B1**

(12) **EUROPEAN PATENT SPECIFICATION**

(45) Date of publication and mention
of the grant of the patent:
**18.06.2025 Bulletin 2025/25**

(21) Application number: **21200024.4**

(22) Date of filing: **30.09.2021**

(51) International Patent Classification (IPC):
***G01R 31/34*** *(2020.01)*

(52) Cooperative Patent Classification (CPC):
**G01R 31/343**

(54) **SYSTEM, APPARATUS AND METHOD FOR MONITORING FAULTS IN AN ELECTRIC MACHINE**

SYSTEM, VORRICHTUNG UND VERFAHREN ZUR ÜBERWACHUNG VON FEHLERN IN EINER ELEKTRISCHEN MASCHINE

SYSTÈME, APPAREIL ET PROCÉDÉ DE SURVEILLANCE DE DÉFAUTS DANS UNE MACHINE ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**05.04.2023 Bulletin 2023/14**

(73) Proprietor: **Siemens Aktiengesellschaft**
**80333 München (DE)**

(72) Inventors:
• **NAIR, Sudev**
**560078 Bangalore, Karnataka (IN)**
• **KHALIL, Mohamed**
**81379 Munich (DE)**
• **MALIK, Vincent**
**80636 Munich (DE)**
• **WOLF POZZO, Christian Andreas**
**90513 Zirndorf (DE)**

(74) Representative: **Isarpatent**
**Patent- und Rechtsanwälte Barth**
**Charles Hassa Peckmann & Partner mbB**
**Friedrichstrasse 31**
**80801 München (DE)**

(56) References cited:
**CN-A- 113 030 723**

• **PEYMAN MILANFAR ET AL: "Monitoring the Thermal Condition of Permanent-Magnet Synchronous Motors", IEEE TRANSACTIONS ON AEROSPACE AND ELECTRONIC SYSTEMS, IEEE SERVICE CENTER, PISCATAWAY, NJ, US, vol. 32, no. 4, 1 October 1996 (1996-10-01), pages 1421 - 1429, XP011081060, ISSN: 0018-9251**

**Description**

The present invention relates to fault monitoring, and more particularly relates to a system and method for monitoring faults in an electric machine.

Electric machines such as motors and generators experience faults due to several factors such as manufacturing defects, aging or operations outside specifications. Early identification and localization of such faults is necessary for reactive or corrective maintenance of the electric machine. However, identification and localization of such faults typically require a number of physical sensors to be installed on the electric machine. In case of brownfield systems, i.e. already fielded electric machines, retrofitting of such sensors may be a tedious task. Further to the above, failure of physical sensors lead to erroneous measurements and may result in delayed identification of faults.

Conventional Motor Current Signature Analysis (MCSA) requires a current transformer to measure a current signal associated with the electric machine. The current signal is further analysed in frequency domain in order to determine faults in the electric machine. However, existing art does not facilitate determination of current signature from other operational parameters such as magnetic flux, vibration and temperature associated with components of the electric machine. Consequently, a faulty current transformer may lead to erroneous results during MCSA.

The document CN 113 030 723 A discloses a monitoring system for the analysis of the condition of an AC asynchronous motor. Data from the motor and its surroundings (voltage, current, vibration and temperature) is acquired and processed and a fault diagnosis is released based on a number of characteristic parameters. The diagnosis is obtained using a model and edge computing.

In Peyman Milanfar et al: "Monitoring the Thermal Condition of Permanent-Magnet Synchronous Motors", IEEE Transactions of Aerospace and Electronic Systems, IEEE Service Center, Piscataway, NJ, US, vol. 32, no. 4, pages 1421-1429, an approach to monitor the condition of small permanent-magnet synchronous motors is provided. Voltages and currents are used to provide a temperature estimation of the different parts of the motor, which is compared with measurements of the temperature and predictions of a thermal model. When the discrepancies go above some given thresholds, a failure is detected and a warning is issued.

Existing art also discloses use of current estimated from stray flux of an electric machine for MCSA. The current is estimated based on proportionality between current and flux. However, as the stray flux is feeble, current estimated from the stray flux may not provide adequate information on faults in the electric machine.

Furthermore, according to ISO 20958-2013, any distortion in the air gap flux density due to defects on either rotor or stator sets up an axial homopolar flux in the shaft that can be detected by a search coil fitted around the shaft. A range of both stator and rotor defects can be deduced from the spectrum of the axial flux obtained by carrying out a Fourier transform on the search coil waveform. The technique is applicable to a wide range of motors but there is the possibility that, on some motor designs, the enclosure can attenuate the amplitude of the axial flux detected by a search coil mounted outside it. This makes the quantitative estimation of the extent of damage difficult without fingerprinting of individual motors.

In light of the above factors, there exists a need for a mechanism for monitoring faults in electric machine based on different operational parameters.

Therefore, it is an object of the present invention to provide a system and method for monitoring faults in an electric machine.

Disclosed herein is a method for monitoring faults in an electric machine. The term 'fault' as used herein refers to an anomaly that may eventually lead to failure of the electric machine. Electric machines include any rotating equipment that operates on the principle of electromagnetic induction. Non-limiting examples of electric machines include AC generators, DC generators, AC motors, DC motors, permanent magnet machines, induction machines and brushed machines. The method comprises obtaining a reference measurement from at least one sensor associated with the electric machine. The reference measurement corresponds to stray flux outside a casing of the electric machine.

The method further comprises generating a characteristic signature based on the reference measurement using a digital twin of the electric machine. The digital twin is a virtual representation indicating a state of the electric machine in real-time. In an embodiment, the step of generating the characteristic signature based on the reference measurement comprises updating the digital twin based on the reference measurement. Further, a simulation model is configured based on the updated digital twin. The simulation model is executed in a simulation environment to generate a simulation result. The simulation result is indicative of the characteristic signature.

In an embodiment, the simulation result indicates airgap flux associated with the electric machine. In a further embodiment, the characteristic signature comprises a time-series signal corresponding to an operational parameter associated with the electric machine, computed from the simulation result using at least one regression model. The regression model indicates a relation between the reference measurement and the operational parameter. The operational parameter is at least one of current, temperature and vibration associated with one or more components of the electric machine.

Advantageously, the characteristic signature is generated by configuring the digital twin based on the reference measurement. Consequently, the need for inputs from multiple physical sensors is eliminated.

The method further comprises analyzing the characteristic signature to identify a fault associated with the electric machine. In an embodiment, the step of analyzing the characteristic signature to identify the fault further comprises generating a frequency domain representation corresponding to a time-domain signal associated with the operational parameter. Further, at least one feature associated with the frequency domain representation is analyzed to determine the fault.

Advantageously, the present invention facilitates automatically identifying and localizing faults from the characteristic signature using regression models, thereby eliminating manual efforts required for identifying and localizing faults.

In an embodiment, the method further comprises classifying the fault into one of a mechanical fault and an electrical fault based on the analysis of the characteristic signature. The method further comprises outputting a notification indicating a visual representation of the fault on an output device. In an embodiment, the method further comprises determining a maintenance activity based on the classification of the fault. Further, a notification indicating the maintenance activity is generated on the output device. In an embodiment, the method further comprises controlling operation of the electric machine in real-time based on the fault identified.

Advantageously, the present invention provides visual representation of the fault for easy identification of faulty components by maintenance personnel. Further, recommendations for maintanence activities based on faults detected in real-time, thereby eliminating delays with initiation of reactive maintenance activities.

Disclosed herein is also an apparatus for monitoring faults in an electric machine. The apparatus comprises one or more processing units and a memory unit communicatively coupled to the one or more processing units. The memory unit comprises a fault monitoring module stored in the form of machine-readable instructions executable by the one or more processing units, wherein the fault monitoring module is configured to perform method steps according to any of the method steps described above.

Disclosed herein is also a system for monitoring faults in an electric machine. The system comprises at least one sensing unit configured to provide a reference measurement associated with the electric machine and an apparatus according as described above, communicatively coupled to the at least one sensing unit. The apparatus is configured to monitor faults in the electric machine according to any of the method steps described above.

Disclosed herein is also a computer-readable medium, on which program code sections of a computer program are saved, the program code sections being loadable into and/or executable by the one or more processing units comprised in the apparatus of the system described above, which performs the method as described above when the program code sections are executed.

The realization of the invention by a computer program product and/or a non-transitory computer-readable storage medium has the advantage that computer systems can be easily adopted by installing computer program in order to work as proposed by the present invention.

The computer program product can be, for example, a computer program or comprise another element apart from the computer program. This other element can be hardware, for example a memory device, on which the computer program is stored, a hardware key for using the computer program and the like, and/or software, for example a documentation or a software key for using the computer program.

The above-mentioned attributes, features, and advantages of the present invention and the manner of achieving them, will become more apparent and understandable (clear) with the following description of embodiments of the invention in conjunction with the corresponding drawings. The illustrated embodiments are intended to illustrate, but not limit the invention.

The present invention is further described hereinafter with reference to illustrated embodiments shown in the accompanying drawings, in which:

FIG 1A  illustrates a block diagram of a system for monitoring faults in an induction motor, in accordance with an embodiment of the present invention;

FIG 1B  illustrates block diagram of an apparatus for monitoring faults in the induction motor, in accordance with an embodiment of the present invention;

FIG 2  illustrates a block diagram of a set-up for calibrating a simulation model of an induction motor, in accordance with an embodiment of the present invention;

FIG 3A  shows a workflow indicating generation of current spectrum from stray flux signal, in accordance with an exemplary embodiment of the present invention;

FIG 3B  shows a workflow indicating generation of thermal spectrum associated with one or more internal components of the induction motor, in accordance with an exemplary embodiment of the present invention;

FIG 3C  shows a workflow indicating generation of current spectrum from real-time stray flux measurement and real-time temperature measurement associated with the induction motor, in accordance with an exemplary embodiment of the present invention;

FIG 3D  shows a workflow indicating generation of vibration spectrum associated with one or more internal components of the induction motor, in accordance with an exemplary embodiment of the present invention; and

FIG 4  shows a flowchart of a method of monitoring faults in an electric machine, in accordance with an embodiment of the present invention.

Hereinafter, embodiments for carrying out the present invention are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

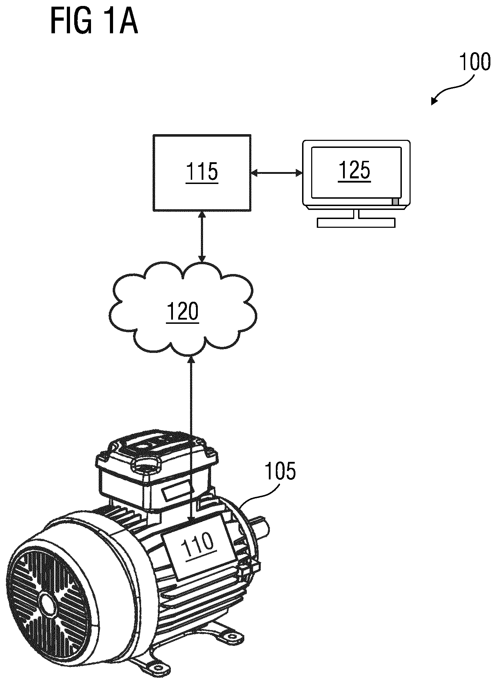

FIG 1A illustrates a block diagram of a system 100 for monitoring faults in an induction motor 105, in accordance with an embodiment of the present invention. The system 100 includes at least one sensing unit 110 configured for obtaining a reference measurement associated with the induction motor 105. The at least one sensing unit 110 is communicatively coupled to an apparatus 115 over a network 120. The apparatus is further coupled to an output device 125.

The apparatus 115 is configured to identify and localize faults in the induction motor 105 based on an output of the at least one sensing unit. The induction motor 105 comprises a stator, a rotor and a casing outside the stator. The at least one sensing unit is a flux sensor mounted on a casing of the induction motor 105. The flux sensor is configured to measure a stray flux outside the casing of the induction motor 105. In another embodiment, the sensing unit 110 is a sensor box comprising one or more of thermal sensors, vibration sensors and flux sensors.

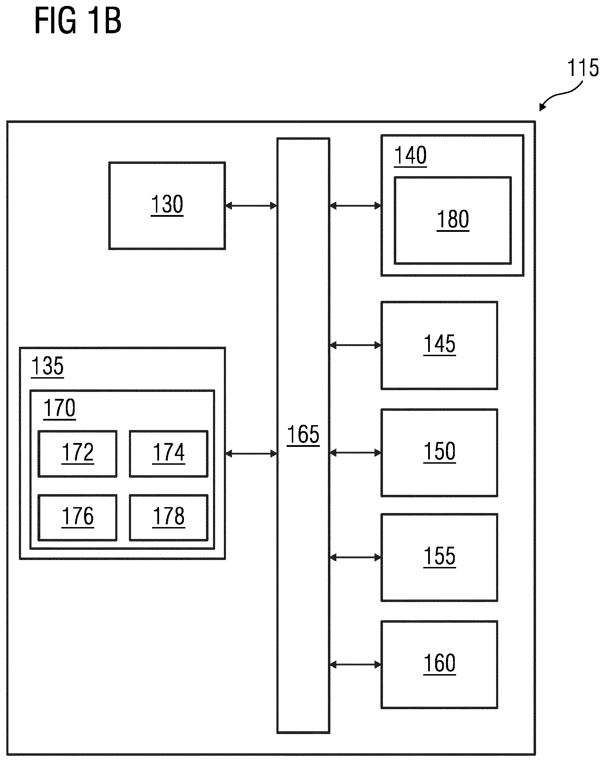

The apparatus 115 comprises a processing unit 130, a memory 135, a storage unit 140, a communication module 145, a network interface 150, an input unit 155, an output unit 160, a standard interface or bus 165 as shown in FIG 1B. The apparatus 115 can be a (personal) computer, a workstation, a virtual machine running on host hardware, a microcontroller, or an integrated circuit. As an alternative, the apparatus 115 can be a real or a virtual group of computers (the technical term for a real group of computers is "cluster", the technical term for a virtual group of computers is "cloud").

The term 'processing unit', as used herein, means any type of computational circuit, such as, but not limited to, a microprocessor, a microcontroller, a complex instruction set computing microprocessor, a reduced instruction set computing microprocessor, a very long instruction word microprocessor, an explicitly parallel instruction computing microprocessor, a graphics processor, a digital signal processor, or any other type of processing circuit. The processing unit 130 may also include embedded controllers, such as generic or programmable logic devices or arrays, application specific integrated circuits, single-chip computers, and the like. In general, the processing unit 130 may comprise hardware elements and software elements. The processing unit 130 can be configured for multithreading, i.e., the processing unit 130 may host different calculation processes at the same time, executing the either in parallel or switching between active and passive calculation processes.

The memory 135 may include one or more of a volatile memory and a non-volatile memory. The memory 135 may be coupled for communication with the processing unit 130. The processing unit 130 may execute instructions and/or code stored in the memory 135. A variety of computer-readable storage media may be stored in and accessed from the memory 135. The memory 135 may include any suitable elements for storing data and machine-readable instructions, such as read only memory, random access memory, erasable programmable read only memory, electrically erasable programmable read only memory, hard drive, removable media drive for handling compact disks, digital video disks, diskettes, magnetic tape cartridges, memory cards, and the like.

The memory 135 comprises a fault monitoring module 170 stored in the memory 135 in the form of machine-readable instructions and executable by the processing unit 130. These machine-readable instructions when executed causes the processing unit 130 to monitor faults associated with the induction motor 105. The fault monitoring module 170 comprises at least a preprocessing module 172, a simulation module 174, an analysis module 176 and a notification module 178.

The preprocessing module 172 is configured for obtaining a reference measurement from the at least one sensing unit associated with the induction motor 105. The term 'reference measurement' as used herein refers to at least one value of an operational parameter sensed by the at least one sensing unit. According to the invention, the reference parameter is stray flux. The simulation module 174 is configured for generating a characteristic signature based on the reference measurement using a digital twin of the induction motor 105. The digital twin is a virtual representation indicating a state of the induction motor 105 in real-time. The term 'characteristic signature' as used herein indicates denotes time-series signal corresponding to an operational parameter at a point on the induction motor 105. The point indicates a position on the surface of a component of the induction motor 105. The characteristic signature may correspond to an operational parameter such as current, flux, temperature and vibration levels in at least one component of the induction motor 105.

The analysis module 176 is configured for analyzing the characteristic signature generated by the digital twin to identify a fault associated with the induction motor 105. The notification module 178 is configured for outputting a notification indicating a visual representation of the fault based on the characteristic signature, on the output device 125. Non-limiting examples of output devices include workstations, personal computers, smartphones, personal digital assistants and tablets.

The storage unit 140 comprises a non-volatile memory which stores data required for updating or calibrating the digital twin. The storage unit 140 may further comprise a database 180 storing lookup tables relating faults to features, parameters related to regression models, maintenance activities to be recommended for specific types of faults etc. The input unit 155 may include input means such as keypad, touchsensitive display, camera, etc. capable of receiving input signal. The output unit 160 may include output means such as displays. The bus 165 acts as interconnect between the processing unit 130, the memory 135, the storage unit 140, and the network interface 150.

The communication module 145 enables the apparatus 115 to communicate with the output device 125. The communication module 145 may support different standard communication protocols such as Transport Control Protocol/Internet Protocol (TCP/IP), Profinet, Profibus, and Internet Protocol Version (IPv).

According to an embodiment of the present invention, the apparatus 115 can be an edge computing device. As used herein "edge computing" refers to computing environment that is capable of being performed on an edge device (e.g., connected to sensing units in an industrial setup and one end and to a remote server(s) such as for computing server(s) or cloud computing server(s) on other end), which may be a compact computing device that has a small form factor and resource constraints in terms of computing power. A network of the edge computing devices can also be used to implement the apparatus 115. Such a network of edge computing devices is referred to as a fog network.

In another embodiment, the apparatus 115 is a cloud computing system having a cloud computing based platform configured to provide a cloud service for monitoring faults in an induction motor 105. As used herein, "cloud computing" refers to a processing environment comprising configurable computing physical and logical resources, for example, networks, servers, storage, applications, services, etc., and data distributed over the network 120, for example, the internet. The cloud computing platform may be implemented as a service for monitoring faults in an induction motor 105. In other words, the cloud computing system provides on-demand network access to a shared pool of the configurable computing physical and logical resources. The network 120 is, for example, a wired network, a wireless network, a communication network, or a network formed from any combination of these networks.

Those of ordinary skilled in the art will appreciate that the hardware depicted in FIGs 1A and 1B may vary for different implementations. For example, other peripheral devices such as an optical disk drive and the like, Local Area Network (LAN)/ Wide Area Network (WAN)/ Wireless (e.g., Wi-Fi) adapter, graphics adapter, disk controller, input/output (I/O) adapter, network connectivity devices also may be used in addition or in place of the hardware depicted. The depicted example is provided for the purpose of explanation only and is not meant to imply architectural limitations with respect to the present disclosure.

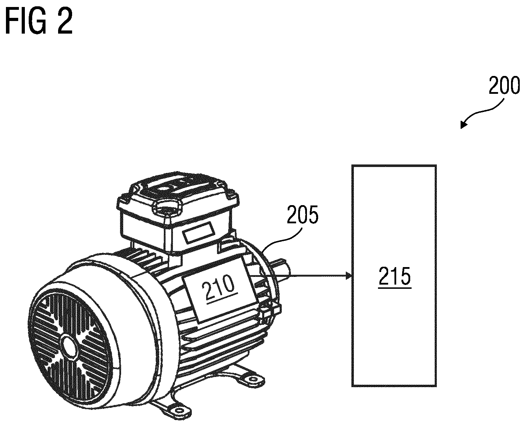

FIG 2 illustrates a block diagram of a set-up 200 for calibrating a simulation model of an induction motor 205, in accordance with an embodiment of the present invention. In the present embodiment, the simulation model corresponds to a 5.5kW, 4 pole LV induction motor.

The set-up 200 comprises a sensing unit 210 configured to measure operational parameters associated with the induction motor 205. The sensing unit 210 is communicatively coupled to an apparatus 215 (similar to the apparatus 115). The sensing unit 210 includes one or more flux sensors configured to measure stray flux associated with the induction motor 205. The sensing unit 210 further includes a plurality of thermal sensors. Each of the thermal sensors is configured to measure a temperature associated with at least one component of the induction motor 205. In an embodiment, six thermal sensors are mounted on stator slots of the induction motor 205 and two thermal sensors are mounted on bearings associated with a shaft of the induction motor 205. The sensing unit 210 further includes one or more vibration sensors configured to measure a vibration associated with one or more components of the induction motor 205.

In an embodiment, a simulation model is calibrated based on experimental data. The experimental data comprises outputs from at least one of the sensing units for known operating conditions of the induction motor 205. The operating conditions may include, but not limited to, speed, torque, ambient temperature etc. Non-limiting examples of faults that may potentially occur in the induction motor 205 include angular misalignment of rotor, parallel misalignment of rotor, eccentricity and breakage of rotor bar.

The experimental data is generated for one or more healthy states and one or more unhealthy states of the induction motor 205. The term 'healthy state' as used herein refers to an ideal state of the induction motor 205 in the absence of faults. The term 'unhealthy states' refers to a state of the induction motor 205 in the presence of one or more faults. The one or more faults are introduced into the induction motor 205 in order to obtain the experimental data corresponding to the unhealthy states.

In the present embodiment, the experimental data comprises a flux signal observed at a point on the casing. For example, the experimental data may include flux signals corresponding to healthy and unhealthy states of the induction motor 205. In an example, the unhealthy states may correspond to broken rotor bar, angular misalignment and parallel misalignment. The observed flux signal comprises a time-series plot of flux density measured by the sensing unit 210 on the casing. For example, the flux signal may indicate time-series plot of radial flux measured at a point on the casing. In another example, the flux signal indicates axial flux at a point on the casing.

The simulation model is configured to generate electromagnetic simulations of the induction motor 205 in a simulation environment. The electromagnetic simulations are performed using the simulation model for the same set of operating conditions and faults used for obtaining the experimental data. The simulation is performed by firstly, configuring the simulation model based on specifications of the induction motor 205. The specifications of the induction motor 205 may include, but not limited to, dimensions, geometry, materials properties of components associated with the induction motor 205, load capacity, electrical phases, ratings etc. The material properties of the components may include hysteresis loop information for the components. Further, simulation instances of the simulation model are generated corresponding to one or more healthy states and one or more unhealthy states. The simulation instances are further executed to generate the simulation data. In the present embodiment, the simulation data corresponds to flux signal associated with the induction motor 205.

The output of the electromagnetic simulation may comprise a two-dimensional or three-dimensional rendering of magnetic field associated with the induction motor 205. More specifically, the rendering may indicate stray flux density around the casing of the induction motor 205 as well as flux density within an airgap between the stator and the rotor of the induction motor 205. The flux signal comprises a time-series plot of simulated flux values at a point on the casing as shown in FIG. The point on the casing may be identified using coordinates in the two-dimensional or three-dimensional rendering. It must be understood that coordinates on the rendering used for obtaining the simulated flux values may correspond to the point on the casing used for obtaining the experimental data.

In an embodiment, the simulation model is calibrated based on a plurality of features FE1, FE2, FE3...FEN associated with the simulated flux signal and observed flux signal. In a preferred embodiment, the features FE1, FE2, FE3...FEN are identified from a frequency-domain representation of the simulated flux signal and the observed flux signal. The frequency-domain representation of flux signal is hereinafter referred to as flux spectrum. The flux spectrum is obtained from time-series representation of the flux signal using a suitable transform function. In a preferred embodiment, the transform function is Fast Fourier Transform. For example, the features FE1, FE2, FE3...FEN may include peak amplitudes or amplitudes at specific frequencies in the flux spectrum. The specific frequencies may include a running frequency of the induction motor 205, multiples of the running frequency or a frequency characteristic to a specific fault.

In an embodiment, the simulation model is calibrated by an expert. The expert manually identifies one or more significant model parameters from a plurality of model parameters associated with the simulation model, based on the flux spectrum. The model parameters are further manually tuned to reduce deviations between features FE1, FE2, FE3...FEN of the simulated flux spectrum and corresponding features of observed flux spectrum.

In another embodiment, the simulation model is calibrated using optimisation techniques. For example, an optimization tool may be used to optimize the model parameters such that deviations between features in the simulated flux spectrum and features in the observed flux spectrum are minimized. The optimization tool may iteratively vary the model parameters based on a predefined optimization algorithm until the deviations are minimized. Further, the model parameters corresponding to a minimal deviation is identified as the optimized model parameters. It must be understood by a person skilled in the art that optimization tools are preferable when number of observed values is at least equal to the number of model parameters corresponding to the simulation model.

In yet another embodiment, machine learning approaches may be used to determine the optimized model parameters. In an implementation, machine learning models including, but not limited to, artificial neural networks and support vector machines may be used to optimize the model parameters. The machine learning model is trained to identify model parameters to reduce differences between features of the observed flux spectrum and simulated flux spectrum. The machine learning approach is used when number of observed features is greater than the number of model parameters.

Upon calibration, one or more correlations between the features FE1, FE2, FE3...FEN and at least one fault are identified. In an example, the features are correlated by performing a plurality of simulations using the simulation model for different faults. More specifically, the simulations are performed by modifying model parameters of the simulation model in order to emulate one or more faults. The simulations may be performed for varying magnitudes of the one or more faults. For example, if the fault is parallel misalignment, the simulations are performed for different values of parallel misalignment.

Upon simulation, values of the features FE1, FE2, FE3...FEN corresponding to different faults are obtained. For example, the values of the features FE1, FE2, FE3...FEN corresponding to radial displacements of 0.02 mm, 0.04 mm .. 0.22 mm of the rotor may be obtained from simulation. Further, a correlation coefficient between the radial displacement and each of the features FE1, FE2, FE3...FEN is computed. The correlation coefficients may be computed using standard correlation analysis techniques including, but not limited to, Pearson's correlation analysis technique.

In Pearson's correlation analysis technique, if there are two features X and Y and there are n samples corresponding to each of the features, the correlation coefficient corresponding to the features X and Y is given by:

$$r_{xy} = \frac{n \sum x_i y_i - \sum x_i \sum y_i}{\sqrt{n \sum x_i^2 - (\sum x_i)^2} \sqrt{n \sum y_i^2 - (\sum y_i)^2}}.$$

Based on the correlation coefficients, a degree of correlation between the fault and each of the features FE1, FE2, FE3...FEN is identified. For example, if a magnitude of the correlation coefficient corresponding to a first feature FE1 is greater than or equal to 0.9, the first feature FE1 is considered to be highly correlated with the fault. If the correlation coefficient corresponding to a second feature FE2 is close to 0, the second feature FE2 may be considered as less correlated with the fault. In an example, a feature may be considered highly correlated if a magnitude of the correlation coefficient is greater than 0.5. Otherwise, the feature may be considered less correlated.

Similarly, correlations between features associated with frequency-domain representations corresponding to different operational parameters are computed. For example, correlations between flux spectrum and current spectrum are computed based on features associated with their respective frequency domain representations for identical time intervals and faults.

In an example, the output of the simulation model includes spatial distribution of flux densities in a stator core, rotor core and a core assembly of the induction motor 205. The plurality of features FE1, FE2, FE3, FE4...FEN, may be obtained from flux signals associated with at least one point on the stator core, rotor core or the core assembly. More specifically, the features are extracted from frequency domain representation of the flux signal, that is the flux spectrum, for a specific interval of time. For example, features associated with the flux spectrum may be FE1, FE2, ... FEN and the features associated with the current spectrum may include I1, I2.. Im. Further, correlation coefficients corresponding to each pair of the features (FE1, I1), (FE2, I1)... (FEN, Im) are computed using the correlation analysis techniques using Pearson's correlation analysis technique as explained above.

Based on the correlation coefficients, a first regression model is generated for flux and current. The first regression model may be further used to estimate instantaneous values of current at a point on the induction motor 205 based on a flux measurement, during real-time operation. Similarly, regression models corresponding to different pairs of operational parameters may be estimated. For example, a second regression model may relate airgap flux and temperature at a point on the casing based on features corresponding to flux spectrum and thermal spectrum for different operating conditions and faults. In yet another example, a third regression model may relate airgap flux and vibration at a point on the casing based on features corresponding to flux spectrum and vibration spectrum for different operating conditions and faults. Each of the regression models may be one of a linear regression model and a non-linear regression model. Each of the regression models is associated with an operational parameter associated with a component of the induction motor 205. For example, a first regression model may correspond to temperature at a point in the windings, a second regression model may provide temperature at a point in the core assembly, a third regression model may provide current through the winding and so on. It must be understood that a plurality of regression models may be used for the same operational parameter in order to compute value of the operational parameter corresponding to a plurality of components. Therefore, each of the regression models may be considered equivalent a virtual sensor. The location of the virtual sensor may be modified if required by calibrating a regression model based on position of the component to be monitored.

In an embodiment, pairs of highly correlated features corresponding to a pair of operational parameters may be identified. Further, one of the features among the pair of highly correlated features is eliminated from the plurality of features. For example, if correlation coefficient corresponding to the pair of features FE3 and I2 is 0.96, the feature FE3 may be eliminated from the plurality of features FE1, FE2, FE3...FEN, I1, I2,..Im. The remaining features FE1, FE2, FE4...FEN, I1, I2,..Im are further used for predicting faults in the induction motor 205.

The simulation model is calibrated in real-time during operation based on output of a flux sensor installed on the casing. For example, if the value of flux predicted by the simulation model deviates from the output of the flux sensor, the simulation model is automatically recalibrated based on the output of the flux sensor. In another example, a notification indicating the deviation may be generated on an output device (similar to the output device 125). Further, a human operator may manually initiate recalibration of the simulation model.

In another embodiment, the simulation model is configured to simulate a current spectrum associated with one or more points on the induction motor 205. The simulation model is calibrated based on experimental data obtained from a Hall effect sensor installed on the casing of the induction motor 205. Further, outputs from the calibrated simulation model is used to obtain regression models based on correlations between signals corresponding to current and other operational parameters. Similarly, correlations between features of the current spectrum and one or more faults may also be determined.

In yet another embodiment, the simulation model is configured to simulate a thermal spectrum based on copper losses, iron losses and frictional losses in different components of the induction motor 205. The simulation model is further calibrated based on experimental data obtained from the thermal sensors. Further, outputs from the calibrated simulation model is used to obtain regression models based on correlations between signals corresponding to temperature and other operational parameters. Similarly, correlations between features of the thermal spectrum and one or more faults may also be determined. Similarly, the simulation model may also be configured to simulate vibration in different parts of the induction motor 205.

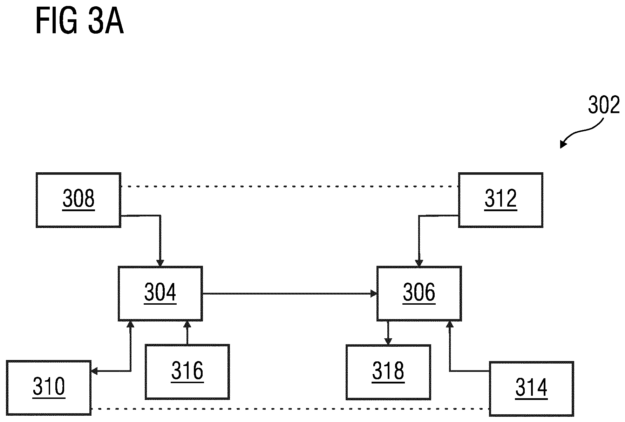

The digital twin comprises a plurality of models that represent operational characteristics associated with the induction motor. Each of the models may include, for example, one or more of physics-based models, hybrid models, artificial intelligence models and so on. For example, one or more first models may indicate thermal characteristics associated with one or more components of the induction motor. In another example, one or more second models may indicate magnetic characteristics associated with one or more components of the induction motor. In yet another example, one or more third models may indicate vibrational characteristics associated with the induction motor. The models are correlated with each other due to interdependence of operational parameters such as flux, temperature, current and vibrations. FIG 3A to 3D illustrate workflows corresponding to generating predictions based on reference measurements from sensors attached to the induction motor, using different models in the digital twin.

FIG 3A shows a workflow 302 indicating generation of current spectrum from stray flux signal, in accordance with an exemplary embodiment of the present invention. The workflow comprises a calibrated first flux model 304 and a calibrated current model 306. The first flux model 304 is built based on simulated flux data 308 generated by an electromagnetic simulation model and calibrated based on experimental flux data 310 generated by a flux sensor attached to the induction motor. Similarly, the current model 306 is calibrated based on simulated current data 312 and experimental current data 314. As shown, experimental flux data 310 is correlated with experimental current data 314 as current varies with flux as per the principle of electromagnetic induction. The dashed line joining 310 and 314 indicates the correlation. Similarly, simulated flux data 308 is correlated with simulated current data 312. During operation, the first flux model 304 is further updated based on real-time stray flux measurement 316 obtained from a flux sensor attached to a casing of the induction motor. Based on the real-time flux spectrum 316 and the regression model corresponding to flux and current, the calibrated current model 306 is updated in real-time. Upon updating, the current model 306 predicts a current spectrum 318 associated with the casing. The simulation model is further updated based on the predicted current spectrum.

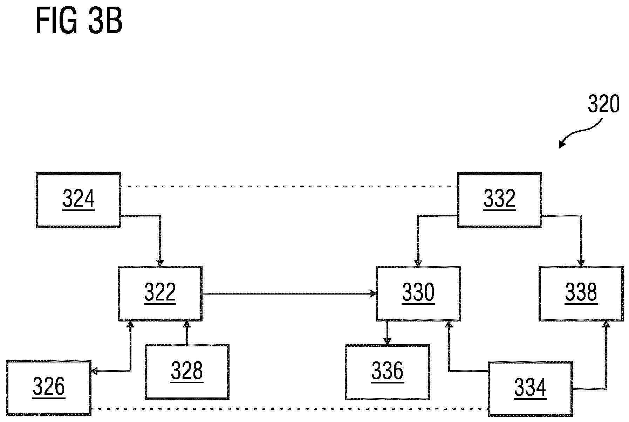

FIG 3B shows a workflow 320 indicating generation of thermal spectrum associated with one or more internal components of the induction motor, in accordance with an exemplary embodiment of the present invention. Here, a first thermal model 322 is built based on simulated thermal data 324 obtained from the simulation model. Further, the first thermal model 322 is calibrated based on experimental thermal data 326 obtained from thermal sensors attached to the induction motor. Upon calibration, the first thermal model 322 may generate a thermal profile of the casing based on real-time thermal data 328 obtained from one or more thermal sensors attached to the casing. Further, a second thermal model 330 corresponding to one or more components of the induction motor may also be calibrated based on regression models corresponding to temperature on the casing (predicted by the first thermal model 322) and temperature on the one or more components. In addition, the second thermal model 330 is also calibrated based on simulation data 332 corresponding to flux changes on the casing with temperature and experimental data 334 corresponding to flux changes in the casing. The calibrated second thermal model 330 is further used to predict temperature 336 associated with one or more components of the induction motor in real-time. The simulation data 332 corresponding to flux changes on the casing with temperature and experimental data 334 corresponding to flux changes in the casing is also used to calibrate a second flux model 338. Upon calibration, the second flux model 338 predicts flux changes in the casing based on a real-time temperature measurement obtained from thermal sensors attached to the casing. The simulation model is further updated based on the flux changes predicted. Here, the dashed lines represent correlations between flux changes and temperature in the induction motor.

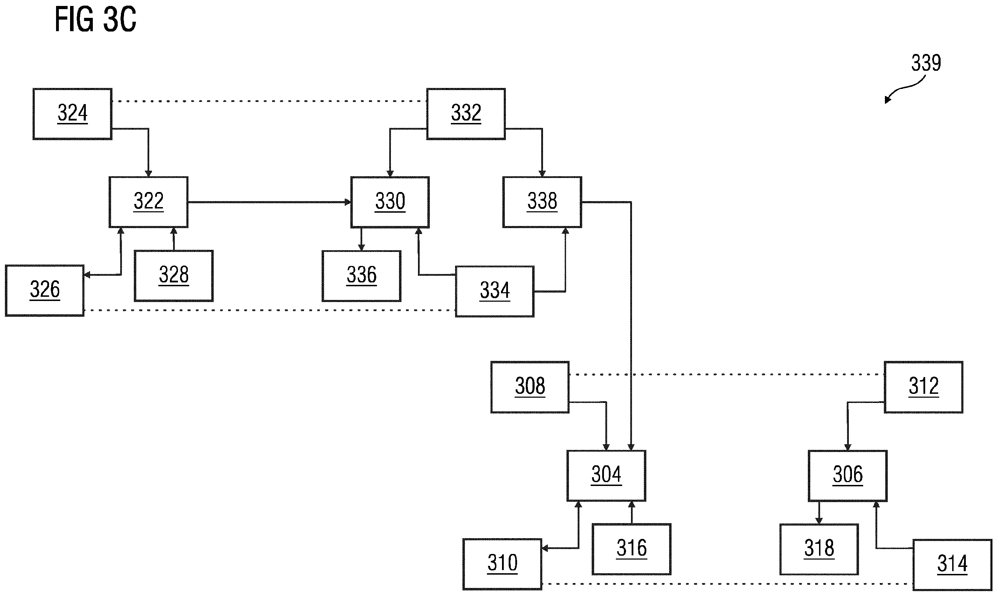

FIG 3C shows a workflow 339 indicating generation of current spectrum from real-time stray flux measurement 316 and real-time temperature measurement 328 associated with the induction motor, in accordance with an exemplary embodiment of the present invention. Here, output from the second flux model 338 is provided to the first flux model 304 in order to capture effects of temperature on windings of the induction motor. For example, flux changes due to temperature changes from the second flux model 338 is used to adjust the flux spectrum predicted by the first flux model 304 for improved accuracy. Further, the current model 306 generates the current spectrum of the induction motor based on the adjusted flux spectrum. The simulation model is further updated based on the current spectrum generated.

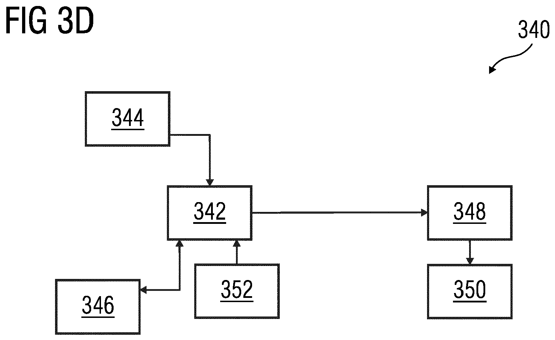

FIG 3D shows a workflow 340 indicating generation of vibration spectrum associated with one or more internal components of the induction motor, in accordance with an exemplary embodiment of the present invention. Here, a first vibration model 342 is built based on simulated vibration data 344 associated with the casing, as obtained from the simulation model. The first vibration model 342 is further calibrated based on experimental vibration data 346 from vibration sensors mounted on the casing. Output of the calibrated first vibration model is further used to calibrate a second vibration model 348 corresponding to one or more components of the induction motor. The second vibration model 348 predicts vibrations in the one or more components based on regression models relating vibration in the casing to vibrations in the one or more components.

Upon calibration, the second vibration model 348 may predict vibration spectrum 350 associated with one or more components of the induction motor based on real-time vibration measurement 352 obtained from vibration sensors mounted on the casing. Similarly, correlations between vibrations, changes in flux and thermal profile of the induction motor may be further used to compute the current spectrum using suitable regression models. For example, vibrations in the airgrap leads to generation of harmonics that affect the airgap flux. The output of the second vibration model 348 may be used to determine the flux changes in the airgap. The flux changes may be further used to adjust the flux spectrum predicted by the second flux model 328 in the workkflow 339.

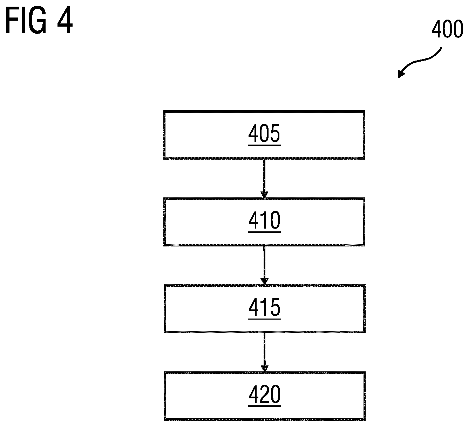

FIG 4 shows a flowchart of a method 400 of monitoring faults in an electric machine, in accordance with an embodiment of the present invention. The method 400 is executed on apparatus 115. In the present embodiment, the electric machine is the induction motor 205.

At step 405, a reference measurement is obtained from at least one sensing unit associated with the electric machine. The reference measurement is stray flux density received from a flux sensor installed on a casing of the induction motor 205. The flux sensor is configured for measuring flux density associated with stray flux emanating from the induction motor 205.

At step 410, a characteristic signature is generated based on the reference measurement using a digital twin of the electric machine. In the present embodiment, the digital twin is a virtual representation indicating a state of the induction motor 205 in real-time. For example, the digital twin comprises a collection of data points pertaining to one or more components of the induction motor 205. The term 'state' as used herein may indicate a real-time condition including values of operational parameters associated with the one or more components.

The digital twin is firstly updated by modifying one or more models in the digital twin based on the stray flux density received from the flux sensor. Further, the simulation model is configured based on the updated digital twin. More specifically, configuring the simulation model comprises calibrating model parameters associated with the simulation model based on a deviation between a stray flux density simulated by the simulation model and the reference measurement. The model parameters are calibrated such that the deviation between the reference measurement and the simulated stray flux density is minimized.

Upon configuring, the simulation model is executed to generate a simulation result. The simulation model is executed by firstly generating a simulation instance corresponding to the reference measurement from the simulation model in real-time. The simulation instance is further executed to generate the simulation result. Similarly, simulation results may be generated in real-time based on real-time values of the reference measurement. In the present embodiment, each of the simulation results comprises a real-time value of airgap flux density corresponding to at least one point in the airgap of the induction motor 205.

Further, value of an operational parameter corresponding to one or more components is determined based on the airgap flux density using at least one regression model corresponding to the operating parameter. The regression models are predetermined based on correlations between signals as explained earlier with reference to FIG 2.

In an embodiment, the at least one regression model is used to determine a real-time value of current passing through a winding of the induction motor 205 from the airgap flux density. In another embodiment, the at least one regression model is used to determine a real-time value of temperature associated with at least one component of the induction motor 205. For example, the regression model may determine real-time temperature of the winding. In yet another embodiment, the at least one regression model is used to determine a real-time value of vibration associated with at least one component of the induction motor 205. For example, the regression model may determine vibration associated with the rotor may be determined.

The value of the operational parameter obtained from the regression model corresponding to a plurality of time-stamps is further used to generate a time-series signal associated with the operational parameter. The time-series signal forms the characteristic signature. Similarly, in alternate embodiments, the characteristic signature may include time-series signals corresponding to temperature or vibration in one or more components of the induction motor 205. The characteristic signature thereby corresponds to output of a virtual sensor on the induction motor 205.

At step 415, the characteristic signature is analyzed to identify a fault associated with the electric machine. The characteristic signature is analyzed by firstly generating a frequency-domain representation of the time-series signal corresponding to the operational parameter. In the present example, frequency-domain representation of the current signal, that is a current spectrum, is generated using Fast Fourier Transform. Further, features associated with the current spectrum are extracted. The features may include, for example, peak amplitudes, amplitudes at predefined frequencies etc. The features are further analyzed in order to identify the fault. More specifically, the features are analyzed based on predetermined correlations between the features and the faults.

In an embodiment, the fault is identified using a look up table. The look up table may store ranges of values associated with each of the features, corresponding to a plurality of faults for normal operating conditions associated with the induction motor 205. In an example, asymmetric sidebands similar to the one shown in FIG 3E in a current spectrum is highly correlated with rotor breakage. Consequently, the fault may be identified as rotor breakage.

In another embodiment, if value of the at least one feature is greater than a predefined range of values for the feature, the fault is identified from a plurality of faults based on predetermined correlations between the feature and each of the faults. For example, if temperature associated with the winding is greater than a predefined range, a fault associated with the winding is identified.

At step 420, a notification indicating a visual representation of the fault based on the characteristic signature, is outputted on the output device. For example, the visual representation may highlight a component of the induction motor 205 corresponding the characteristic signature, when fault is identified. For example, in case of rotor bar breakage, the rotor bar may be highlighted using a predefined colour scheme in a two-dimensional or three-dimensional rendering of the induction motor 205.

In a further embodiment, the fault is classified into one of a mechanical fault and an electrical fault based on analysis of the characteristic signature. For example, the fault is classified into one of a mechanical fault and an electrical fault using a classification model. Based on the classification, a maintenance activity is identified. In an example, the maintenance activity is determined from a graph database, such as a knowledge graph, based on an identifier corresponding to the fault. For example, a node corresponding to 'Mechanical fault' in the knowledge graph may have child nodes corresponding to different mechanical faults such as 'rotor bar breakage', 'eccentricity'. Each of the child nodes may have further sub-nodes indicating an appropriate maintenance activity. For example, if the fault is identified as rotor bar breakage in step 315, the sub-node may indicate maintenance activity as 'replace rotor bar'. Further, a notification indicating the fault and maintenance activity is generated on the output device using suitable text templates. For example, the notification may be of the form *'Rotor bar breakage detected. Replace rotor bar'.*

In a further embodiment, operation of the induction motor 205 is controlled in real-time based on the fault identified. The operation may be controlled by computing a remaining useful life (RUL) of the induction motor 205 using known RUL estimator models. Based on the RUL, operating conditions such as speed of the induction motor 205 may be controlled in order to avoid premature failure of the induction motor 205 before the RUL.

Advantageously, the present invention uses calibrated regression models to determine operational parameters corresponding to one or more components of the electric machine. As a result, faults in the electric machine may be monitored and localized using minimal number of sensors. The characteristic signature may be considered as output of a virtual sensor. Consequently, multiple characteristic signatures may be considered equivalent to multiple virtual sensors. Further, the present invention may be applied to already fielded electric machines thereby eliminating the need for retrofitting additional sensors.

The present invention is not limited to a particular computer system platform, processing unit, operating system, or network. One or more aspects of the present invention may be distributed among one or more computer systems, for example, servers configured to provide one or more services to one or more client computers, or to perform a complete task in a distributed system. For example, one or more aspects of the present invention may be performed on a client-server system that comprises components distributed among one or more server systems that perform multiple functions according to various embodiments. These components comprise, for example, executable, intermediate, or interpreted code, which communicate over a network using a communication protocol. The present invention is not limited to be executable on any particular system or group of system, and is not limited to any particular distributed architecture, network, or communication protocol.

While the invention has been illustrated and described in detail with the help of a preferred embodiment, the invention is not limited to the disclosed examples.

Reference sign list

| | |
|---|---|
| 100 | system for monitoring faults in an electric machine |
| 105 | induction motor |
| 110 | sensing unit |
| 115 | apparatus |
| 120 | network |
| 125 | output device |
| 130 | processing unit, |
| 135 | memory |
| 140 | storage unit |
| 145 | communication module |

| | |
|---|---|
| 150 | network interface |
| 155 | input unit |
| 160 | output unit |
| 165 | standard interface or bus |
| 170 | fault monitoring module |
| 172 | preprocessing module |
| 174 | simulation module |
| 176 | analysis module |
| 178 | notification module |
| 180 | database |
| 200 | set-up for calibrating simulation model |
| 205 | induction motor |
| 210 | plurality of sensing units |
| 215 | apparatus |

**Claims**

1. A computer-implemented method for monitoring faults in an electric machine (105, 205), the method comprising:

   obtaining a reference measurement, by a processing unit (130), from at least one sensing unit associated with the electric machine (105, 205) ), wherein the reference measurement corresponds to stray flux outside a casing of the electric machine (105, 205);
   generating a characteristic signature based on the reference measurement using a digital twin of the electric machine (105, 205), wherein the digital twin is a virtual representation indicating a state of the electric machine (105, 205) in real-time;
   analyzing the characteristic signature to identify a fault associated with the electric machine (105, 205); and
   outputting a notification indicating a visual representation of the fault on an output device (125).

2. The method according to claim 1, wherein generating the characteristic signature based on the reference measurement using the digital twin of the electric machine (105, 205) comprises:

   updating the digital twin based on the reference measurement;
   configuring a simulation model based on the updated digital twin;
   executing the simulation model in a simulation environment to generate a simulation result, wherein the simulation result is indicative of the characteristic signature.

3. The method according to claim 2, wherein the simulation result indicates airgap flux associated with the electric machine (105, 205).

4. The method according to claims 1 and 2, wherein the characteristic signature comprises a time-series signal corresponding to an operational parameter associated with the electric machine (105, 205), computed from the simulation result using at least one regression model.

5. The method according to claim **4,** wherein the regression model indicates a relation between the reference measurement and the operational parameter.

6. The method according to claim 4, wherein the operational parameter is at least one of current, temperature and vibration associated with one or more components of the electric machine (105, 205).

7. The method according to claims 1 and 4, wherein analyzing the characteristic signature to identify the fault associated with the electric machine (105, 205) comprises:

   generating a frequency domain representation corresponding to a time-domain signal associated with the operational parameter; and
   analyzing at least one feature associated with the frequency domain representation to determine the fault.

8. The method according to claim 1 or 7, further comprising:
   classifying the fault into one of a mechanical fault and an electrical fault based on the analysis of the characteristic signature.

9. The method according to claim 8, further comprising:

    determining a maintenance activity based on the classification of the fault; and
    generating a notification indicating the maintenance activity on the output device (125).

10. The method according to claim 1 further comprising:
controlling operation of the electric machine (105, 205) in real-time based on the fault identified.

11. An apparatus (115) for monitoring faults in an electric machine (105, 205), the apparatus (115) comprising:

    one or more processing units (130); and
    a memory unit (135) communicatively coupled to the one or more processing units (130), wherein the memory unit (135) comprises a fault monitoring module (170) stored in the form of machine-readable instructions executable by the one or more processing units (130), wherein the fault monitoring module (170) is configured to perform method steps according to any of the claims 1 to 10.

12. A system (100) for monitoring faults in an electric machine (105, 205), the system (100) comprising:

    at least one sensing unit configured to provide a reference measurement associated with the electric machine (105, 205), wherein the reference measurement corresponds to stray flux outside a casing of the electric machine (105, 205);
    an apparatus (115) according to claim 11, communicatively coupled to the at least one sensing unit, wherein the apparatus (115) is configured to monitor faults in the electric machine (105, 205) according to any of the method claims 1 to 10.

13. A computer-program product having machine-readable instructions stored therein, which when executed by the one or more processing units (130) according to claim 12, causes the said processing units (130) to perform a method according to any of the claims 1 to 10.

**Patentansprüche**

1. Computerimplementiertes Verfahren zum Überwachen von Fehlern in einer elektrischen Maschine (105, 205), wobei das Verfahren Folgendes umfasst:

    Erhalten einer Referenzmessung durch eine Verarbeitungseinheit (130) von mindestens einer Sensoreinheit, die mit der elektrischen Maschine (105, 205) assoziiert ist, wobei die Referenzmessung Streufluss außerhalb eines Gehäuses der elektrischen Maschine (105, 205) entspricht;
    Erzeugen einer charakteristischen Signatur basierend auf der Referenzmessung unter Verwendung eines digitalen Zwillings der elektrischen Maschine (105, 205), wobei der digitale Zwilling eine virtuelle Darstellung ist, die einen Zustand der elektrischen Maschine (105, 205) in Echtzeit angibt;
    Analysieren der charakteristischen Signatur, um einen Fehler zu identifizieren, der mit der elektrischen Maschine (105, 205) assoziiert ist; und
    Ausgeben einer Benachrichtigung, die eine visuelle Darstellung des Fehlers auf einer Ausgabevorrichtung (125) angibt.

2. Verfahren nach Anspruch 1, wobei das Erzeugen der charakteristischen Signatur basierend auf der Referenzmessung unter Verwendung des digitalen Zwillings der elektrischen Maschine (105, 205) Folgendes umfasst:

    Aktualisieren des digitalen Zwillings basierend auf der Referenzmessung;
    Konfigurieren eines Simulationsmodells basierend auf dem aktualisierten digitalen Zwilling;
    Ausführen des Simulationsmodells in einer Simulationsumgebung, um ein Simulationsergebnis zu erzeugen, wobei das Simulationsergebnis die charakteristische Signatur angibt.

3. Verfahren nach Anspruch 2, wobei das Simulationsergebnis einen Luftspaltfluss angibt, der mit der elektrischen Maschine (105, 205) assoziiert ist.

4. Verfahren nach Anspruch 1 und 2, wobei die charakteristische Signatur ein Zeitreihensignal umfasst, das einem Betriebsparameter entspricht, der mit der elektrischen Maschine (105, 205) assoziiert ist und aus dem Simulationsergebnis unter Verwendung mindestens eines Regressionsmodells berechnet wird.

5. Verfahren nach Anspruch 4, wobei das Regressionsmodell eine Beziehung zwischen der Referenzmessung und dem Betriebsparameter angibt.

6. Verfahren nach Anspruch 4, wobei der Betriebsparameter mindestens eines von Strom, Temperatur und Vibration ist, die mit einer oder mehreren Komponenten der elektrischen Maschine (105, 205) assoziiert sind.

7. Verfahren nach Anspruch 1 und 4, wobei das Analysieren der charakteristischen Signatur zum Identifizieren des mit der elektrischen Maschine (105, 205) assoziierten Fehlers Folgendes umfasst:

   Erzeugen einer Frequenzbereichsdarstellung, die einem Zeitbereichssignal entspricht, das mit dem Betriebsparameter assoziiert ist; und
   Analysieren mindestens eines Merkmals, das mit der Frequenzbereichsdarstellung assoziiert ist, um den Fehler zu bestimmen.

8. Verfahren nach Anspruch 1 oder 7, ferner umfassend:
   Klassifizieren des Fehlers in einen von einem mechanischen Fehler und einem elektrischen Fehler basierend auf der Analyse der charakteristischen Signatur.

9. Verfahren nach Anspruch 8, ferner umfassend:

   Bestimmen einer Wartungsaktivität basierend auf der Klassifizierung des Fehlers; und
   Erzeugen einer Benachrichtigung, die die Wartungsaktivität auf der Ausgabevorrichtung (125) angibt.

10. Verfahren nach Anspruch 1, ferner umfassend:
    Steuern des Betriebs der elektrischen Maschine (105, 205) in Echtzeit basierend auf dem identifizierten Fehler.

11. Einrichtung (115) zum Überwachen von Fehlern in einer elektrischen Maschine (105, 205), wobei die Einrichtung (115) Folgendes umfasst:

    eine oder mehrere Verarbeitungseinheiten (130); und
    eine Speichereinheit (135), die kommunikativ mit der einen oder den mehreren Verarbeitungseinheiten (130) gekoppelt ist, wobei die Speichereinheit (135) ein Fehlerüberwachungsmodul (170) umfasst, das in Form von maschinenlesbaren Anweisungen gespeichert ist, die durch die eine oder die mehreren Verarbeitungseinheiten (130) ausführbar sind, wobei das Fehlerüberwachungsmodul (170) dazu konfiguriert ist, die Verfahrensschritte nach einem der Ansprüche 1 bis 10 auszuführen.

12. System (100) zum Überwachen von Fehlern in einer elektrischen Maschine (105, 205), wobei das System (100) Folgendes umfasst:

    mindestens eine Sensoreinheit, die dazu konfiguriert ist, eine Referenzmessung bereitzustellen, die mit der elektrischen Maschine (105, 205) assoziiert ist, wobei die Referenzmessung Streufluss außerhalb eines Gehäuses der elektrischen Maschine (105, 205) entspricht;
    eine Einrichtung (115) nach Anspruch 11, die kommunikativ mit der mindestens einen Sensoreinheit gekoppelt ist, wobei die Einrichtung (115) dazu konfiguriert ist, Fehler in der elektrischen Maschine (105, 205) nach einem der Verfahrensansprüche 1 bis 10 zu überwachen.

13. Computerprogrammprodukt mit darin gespeicherten maschinenlesbaren Anweisungen, die bei Ausführung durch die eine oder die mehreren Verarbeitungseinheiten (130) nach Anspruch 12 die Verarbeitungseinheiten (130) veranlassen, ein Verfahren nach einem der Ansprüche 1 bis 10 durchzuführen.

**Revendications**

1. Procédé mis en œuvre par ordinateur pour surveiller des défauts dans une machine électrique (105, 205), le procédé comprenant les étapes suivantes :

obtenir, par une unité de traitement (130), une mesure de référence à partir d'au moins une unité de détection associée à la machine électrique (105, 205), la mesure de référence correspondant à un flux parasite à l'extérieur d'un boîtier de la machine électrique (105, 205) ;
générer une signature caractéristique sur la base de la mesure de référence à l'aide d'un jumeau numérique de la machine électrique (105, 205), le jumeau numérique étant une représentation virtuelle indiquant un état de la machine électrique (105, 205) en temps réel ;
analyser la signature caractéristique pour identifier un défaut associé à la machine électrique (105, 205) ; et
émettre une notification indiquant une représentation visuelle du défaut sur un dispositif de sortie (125).

2. Procédé selon la revendication 1, dans lequel la génération de la signature caractéristique sur la base de la mesure de référence à l'aide du jumeau numérique de la machine électrique (105, 205) comprend les étapes suivantes :

mettre à jour le jumeau numérique sur la base de la mesure de référence ;
configurer un modèle de simulation sur la base du jumeau numérique mis à jour ;
exécuter le modèle de simulation dans un environnement de simulation afin de générer un résultat de simulation, le résultat de simulation étant indicatif de la signature caractéristique.

3. Procédé selon la revendication 2, dans lequel le résultat de simulation indique le flux dans l'entrefer associé à la machine électrique (105, 205).

4. Procédé selon les revendications 1 et 2, dans lequel la signature caractéristique comprend un signal de série chronologique correspondant à un paramètre opérationnel associé à la machine électrique (105, 205), calculé à partir du résultat de simulation à l'aide d'au moins un modèle de régression.

5. Procédé selon la revendication 4, dans lequel le modèle de régression indique une relation entre la mesure de référence et le paramètre opérationnel.

6. Procédé selon la revendication 4, dans lequel le paramètre opérationnel est au moins l'un parmi le courant, la température et la vibration associés à un ou plusieurs composants de la machine électrique (105, 205).

7. Procédé selon les revendications 1 et 4, dans lequel l'analyse de la signature caractéristique pour identifier le défaut associé à la machine électrique (105, 205) comprend les étapes suivantes :

générer une représentation dans le domaine fréquentiel correspondant à un signal dans le domaine temporel associé au paramètre opérationnel ; et
analyser au moins une caractéristique associée à la représentation dans le domaine fréquentiel pour déterminer le défaut.

8. Procédé selon la revendication 1 ou la revendication 7, comprenant en outre l'étape suivante :

classer le défaut en tant que défaut mécanique ou défaut électrique sur la base de l'analyse de la signature caractéristique.

9. Procédé selon la revendication 8, comprenant en outre l'étape suivante :

déterminer une activité de maintenance sur la base de la classification du défaut ; et
générer une notification indiquant l'activité de maintenance sur le dispositif de sortie (125).

10. Procédé selon la revendication 1, comprenant en outre l'étape suivante :

contrôler le fonctionnement de la machine électrique (105, 205) en temps réel sur la base du défaut identifié.

11. Appareil (115) pour surveiller des défauts dans une machine électrique (105, 205), l'appareil (115) comprenant :

une ou plusieurs unités de traitement (130) ; et
une unité (135) de mémoire couplée en communication à l'unité ou aux unités (130) de traitement, l'unité (135) de mémoire comportant un module (170) de surveillance de défaut stocké sous la forme d'instructions lisibles par machine exécutables par l'unité ou les unités (130) de traitement, le module (170) de surveillance de défaut étant configuré pour réaliser les étapes de procédé selon l'une quelconque des revendications 1 à 10.

12. Système (100) pour surveiller des défauts dans une machine électrique (105, 205), le système (100) comprenant :

au moins une unité de détection configurée pour fournir une mesure de référence associée à la machine électrique (105, 205), la mesure de référence correspondant à un flux parasite à l'extérieur d'un boîtier de la machine électrique (105, 205) ;
un appareil (115) selon la revendication 11, couplé de manière communicative à l'au moins une unité de détection, l'appareil (115) étant configuré pour surveiller des défauts dans la machine électrique (105, 205) selon l'une quelconque des revendications de procédé 1 à 10.

13. Produit de programme informatique dans lequel sont stockées des instructions lisibles par machine, qui lorsqu'elles sont exécutées par les une ou plusieurs unités de traitement (130) selon la revendication 12, amènent lesdites unités de traitement (130) à réaliser un procédé selon l'une quelconque des revendications 1 à 10.

FIG 1A

100

115 ⟷ 125

120

105

110

# FIG 1B

115

130

140

180

135

170

172 174

176 178

165

145

150

155

160

FIG 2

# FIG 3A

302

308

312

304

306

310

316

318

314

FIG 3B

FIG 3C

EP 4 160 233 B1

FIG 3D

340

344

342

348

346

352

350

FIG 4

400

```
┌─────────────────┐
│       405       │
└─────────────────┘
         │
         ▼
┌─────────────────┐
│       410       │
└─────────────────┘
         │
         ▼
┌─────────────────┐
│       415       │
└─────────────────┘
         │
         ▼
┌─────────────────┐
│       420       │
└─────────────────┘
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 113030723 A

**Non-patent literature cited in the description**

- **PEYMAN MILANFAR et al.** Monitoring the Thermal Condition of Permanent-Magnet Synchronous Motors. *IEEE Transactions of Aerospace and Electronic Systems, IEEE Service Center, Piscataway, NJ, US*, vol. 32 (4), 1421-1429